# FASCICULE DE BREVET EUROPEEN

(11) **EP 4 002 689 B1**
(45) Date de publication et mention de la délivrance du brevet: **08.07.2026**
(21) Numéro de dépôt: 21208710.0
(22) Date de dépôt: 17.11.2021
(51) Int. Cl.: H03K 4/501, H03K 4/502

(54) **OSCILLATEUR**
OSZILLATOR
OSCILLATOR

(30) Priorité: 24.11.2020 FR 2012048
(43) Date de publication de la demande: 25.05.2022
(73) Titulaire: STMicroelectronics (Rousset) SAS, 13790 Rousset (FR)
(72) Inventeur: BINET, Vincent, AIX EN PROVENCE 13100 (FR); CUENCA, Michel, 13240 SEPTEMES LES VALLONS (FR); GIRARDEAU, Ludovic, 83910 POURRIERES (FR)
(74) Mandataire: Cabinet Beaumont

(56) Documents cités:
- WO-A1-2015/191000
- US-A1- 2018 145 665
- LU YANGYANG ET AL: "A high linearity current-controlled CMOS relaxation oscillator with frequency self-calibration technique", ANALOG INTEGRATED CIRCUITS AND SIGNAL PROCESSING, SPRINGER NEW YORK LLC, US, vol. 92, no. 1, 19 April 2017 (2017-04-19), pages 29 - 37, XP036245595, ISSN: 0925-1030, [retrieved on 20170419], DOI: 10.1007/S10470-017-0973-8

## Description

### Domaine technique

La présente description concerne de façon générale les circuits électroniques, et plus particulièrement les oscillateurs.

### Technique antérieure

Des oscillateurs configurés pour générer un signal périodique binaire, par exemple un signal d'horloge, sont connus. Ces oscillateurs utilisent une comparaison d'au moins une rampe de tension à une tension de consigne pour générer le signal périodique, la pente de la ou des rampes et la tension de consigne déterminant la fréquence du signal périodique généré. La ou les comparaisons sont mises en œuvre respectivement par un ou plusieurs comparateurs de tension, typiquement des amplificateurs opérationnels montés en comparateurs. Le document US 2018/0145665 A1 décrit un exemple d'oscillateur à relaxation. L'article intitulé "A high linearity current-controlled CMOS relaxation oscillator with frequency self-calibration technique", DOI 10.1007/s10470-017-0973-8, décrit lui aussi un oscillateur à relaxation. Le document WO 2015/191000 A1 décrit un oscillateur.

Toutefois, le temps de propagation dans les comparateurs étant sensible aux variations de température de l'oscillateur, une modification de la température de l'oscillateur conduit à une modification de la fréquence du signal périodique généré, ce qui n'est pas souhaitable.

### Résumé de l'invention

Il existe un besoin de pallier tout ou partie des inconvénients des oscillateurs connus, en particulier des oscillateurs connus décrits précédemment.

Un mode de réalisation pallie tout ou partie des inconvénients des oscillateurs connus, en particulier des oscillateurs connus décrits précédemment.

Par exemple, un mode de réalisation pallie tout ou partie des inconvénients des oscillateurs connus liés aux variations de température de ces oscillateurs.

Un mode de réalisation prévoit un dispositif tel que défini par la revendication 1.

Des modes de réalisation spécifiques sont définis par les revendications dépendantes.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente un exemple d'un circuit d'un oscillateur ;
la figure 2 représente des chronogrammes illustrant le fonctionnement idéal de l'oscillateur de la figure 1 ;
la figure 3 représente, de manière schématique et avec des blocs fonctionnels, un mode de réalisation d'un oscillateur ;
la figure 4 représente un chronogramme illustrant le fonctionnement de l'oscillateur de la figure 3 ;
la figure 5 représente de manière plus détaillée un mode de réalisation d'une partie de l'oscillateur de la figure 3 ;
la figure 6 représente de manière plus détaillée un mode de réalisation d'une partie de l'oscillateur de la figure 3 ;
la figure 7 représente de manière plus détaillée un mode de réalisation d'une partie de l'oscillateur de la figure 3 ; et
la figure 8 représente de manière plus détaillée un mode de réalisation de l'oscillateur de la figure 3.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les différents circuits électroniques usuels dans lesquels peut être prévu un oscillateur, notamment pour générer un signal d'horloge, n'ont pas été détaillés, les modes de réalisation et variantes décrits étant compatibles avec ces circuits électroniques usuels.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

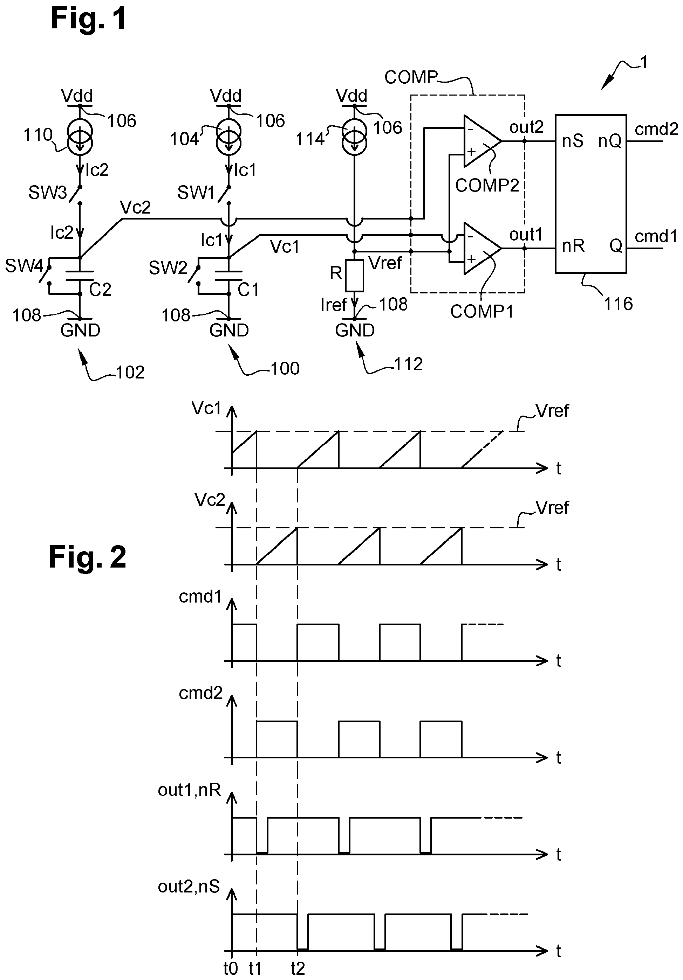

La figure 1 représente un exemple d'un circuit d'un oscillateur 1.

L'oscillateur 1 comprend un générateur 100 de rampes de tension Vc1 et un générateur 102 de rampes de tension Vc2.

Le générateur 100 comprend une source de courant 104, un interrupteur SW1 et une capacité C1 en série, de préférence dans cet ordre, entre un noeud 106 d'application d'une tension d'alimentation Vdd et un noeud 108 d'application d'un potentiel de référence, ici la masse GND, l'interrupteur SW1 reliant la source de courant 104 à la capacité C1. Dans cet exemple, la tension d'alimentation Vdd est positive et référencée par rapport au noeud 108 mis au potentiel de masse GND. Le générateur 100 comprend en outre un interrupteur SW2 en parallèle de la capacité C1. La source de courant 104 délivre un courant constant Ic1. Dans cet exemple, lorsque l'interrupteur SW1 est fermé et que l'interrupteur SW2 est ouvert, la capacité C1 se charge, d'où il résulte une rampe de tension Vc1 aux bornes de la capacité C1, comme on peut le voir en figure 2. Lorsque l'interrupteur SW2 est fermé, le générateur 100 est réinitialisé, ou, dit autrement, la tension Vc1 est réinitialisée, dans cet exemple à 0 V.

De manière similaire, le générateur 102 comprend une source de courant 110, un interrupteur SW3 et une capacité C2 en série, de préférence dans cet ordre, entre les deux noeuds 106 et 108, l'interrupteur SW3 reliant la source de courant 110 à la capacité C2. De préférence, la valeur de la capacité C2 est identique à celle de la capacité C1. Le générateur 102 comprend en outre un interrupteur SW4 en parallèle de la capacité C2. La source de courant 110 délivre un courant constant Ic2, de préférence de même valeur Ic que le courant Ic1. Dans cet exemple, lorsque l'interrupteur SW3 est fermé et que l'interrupteur SW4 est ouvert, la capacité C2 se charge d'où il résulte une rampe de tension Vc2 aux bornes de la capacité C2, comme on peut le voir en figure 2. Lorsque l'interrupteur SW4 est fermé, le générateur 102 est réinitialisé, ou, dit autrement, la tension Vc2 est réinitialisée, dans cet exemple à 0 V.

Une tension Vref de consigne ou de référence est fournie par un générateur de tension 112. Dans cet exemple, le générateur 112 comprend une source de courant 114 fournissant un courant constant Iref, et une résistance R en série avec la source 114 entre les noeuds 106 et 108. La tension Vref correspond alors à la tension aux bornes de la résistance R, la tension Vref étant, dans cet exemple, référencée au noeud 108 auquel est reliée une borne de la résistance R.

L'oscillateur 1 comprend en outre un circuit COMP (délimité par des traits en pointillé en figure 1) configuré pour comparer la tension Vc1 avec la tension de consigne Vref et pour comparer la tension Vc2 avec la tension de consigne Vref. Le circuit COMP est en outre configuré pour fournir un signal binaire out1 dont l'état haut ou bas indique le résultat de la comparaison de la tension Vc1 avec la tension Vref, et pour fournir un signal binaire out2 dont l'état haut ou bas indique le résultat de la comparaison de la tension Vc2 avec la tension Vref. Le circuit COMP comprend par exemple trois entrées recevant les tensions respectives Vref, Vc1 et Vc2.

Dans l'exemple de la figure 1, le circuit COMP est mis en œuvre par un comparateur COMP1 et un comparateur COMP2, les comparateurs COMP1 et COMP2 étant de préférence identiques.

Le comparateur COMP1 est configuré pour comparer la tension Vc1 avec la tension de consigne Vref et pour fournir le signal out1. Dans cet exemple, une entrée inverseuse (-) du comparateur COMP1 reçoit la tension Vc1, et une entrée non inverseuse (+) du comparateur COMP1 reçoit la tension Vref.

De manière similaire, le comparateur COMP2 est configuré pour comparer la tension Vc2 à la tension Vref et pour fournir le signal out2. Dans cet exemple, une entrée inverseuse (-) du comparateur COMP2 reçoit la tension Vc2, et une entrée non inverseuse (+) du comparateur COMP1 reçoit la tension Vref.

L'oscillateur 1 comprend en outre un circuit de commande 116. Le circuit 116 est configuré, sur la base des signaux out1 et out2, pour arrêter une rampe de tension Vc1 et démarrer une rampe de tension Vc2 quand la rampe de tension Vc1 atteint la tension Vref, et pour arrêter une rampe de tension Vc2 et démarrer une rampe de tension Vc1 quand la rampe de tension Vc2 atteint la tension Vref.

Dans cet exemple, le circuit de commande 116 est un verrou RS ayant une entrée nR recevant le signal out1, une entrée nS recevant le signal out2, une sortie nQ fournissant un signal cmd2 de commande des interrupteurs SW2 et SW3, et une sortie Q fournissant un signal de commande cmd1 des interrupteurs SW1 et SW4. Dans cet exemple, le verrou RS est configuré pour mettre le signal cmd1 à l'état haut et le signal cmd2 à l'état bas quand le signal out2 commute à l'état bas alors que le signal out1 est à l'état haut, et pour mettre le signal cmd2 à l'état haut et le signal cmd1 à l'état bas quand le signal out1 commute à l'état bas alors que le signal out2 est à l'état haut. Dans cet exemple, les interrupteurs SW1, SW2, SW3 et SW4 sont ouverts quand leurs signaux de commande respectifs sont à l'état bas, et fermés quand leurs signaux de commande respectifs sont à l'état haut.

La figure 2 représente des chronogrammes illustrant le fonctionnement idéal de l'oscillateur de la figure 1. Plus particulièrement, la figure 2 représente des chronogrammes des tensions Vc1 et Vc2 et des signaux cmd1, cmd2, out1 et out2, les signaux out1 et out2 correspondant aux signaux reçus par les entrées respectivement nR et nS du verrou RS 116 décrit en relation avec la figure 1.

A un instant t0, le signal cmd1 est à l'état haut et le signal cmd2 est à l'état bas, d'où il résulte que les interrupteurs SW1 et SW4 sont fermés et les interrupteurs SW2 et SW3 sont ouverts. Ainsi, le générateur 100 fournit une rampe de tension Vc1, et le générateur 102 est à l'état initial (tension Vc2 nulle dans cet exemple).

A un instant t1 suivant, la rampe Vc1 atteint la tension Vref, d'où il résulte que le signal out1 commute à l'état bas, ce qui entraîne que les signaux cmd1 et cmd2 commutent respectivement à l'état bas et à l'état haut.

Ainsi, à partir de l'instant t1, les interrupteurs SW1 et SW4 sont ouverts et les interrupteurs SW2 et SW3 sont fermés, d'où il résulte que le générateur 102 fournit une rampe de tension Vc2. En outre, la fermeture de l'interrupteur SW2 entraîne que le générateur 100 est mis à l'état initial (tension Vc1 nulle dans cet exemple), d'où il résulte que le signal out1 commute à l'état haut peu de temps après l'instant t1.

A un instant suivant t2, la rampe Vc2 atteint la tension Vref, d'où il résulte que le signal out2 commute à l'état bas, ce qui entraîne que les signaux cmd1 et cmd2 commutent respectivement à l'état haut et à l'état bas.

Ainsi, à partir de l'instant t2, les interrupteurs SW1 et SW4 sont fermés et les interrupteurs SW2 et SW3 sont ouverts, d'où il résulte que le générateur 100 fournit une rampe de tension Vc1. En outre, la fermeture de l'interrupteur SW4 entraîne que le générateur 102 est mis à l'état initial (tension Vc2 nulle dans cet exemple), d'où il résulte que le signal out2 commute à l'état haut peu de temps après l'instant t2.

Après l'instant t2, le fonctionnement de l'oscillateur 1 se poursuit de manière similaire à ce qui a été décrit ci-dessus, d'où il résulte que les signaux cmd1 et cmd2 sont des signaux périodiques.

En considérant que le temps de propagation Tp dans le circuit COMP, ou, dit autrement, dans les comparateurs COMP1 et COMP2, est nul, la fréquence des signaux cmd1 et cmd2 est égale à Ic/(2.C.Vref), avec C la valeur des capacités C1 et C2 et Ic la valeur des courants Ic1 et Ic2. Dit autrement, la fréquence des signaux cmd1 et cmd2 est égale à Ic/(2.C.R.Iref), c'est-à-dire à un demi de 1/(R.C) quand le courant Iref a la valeur Ic. L'oscillateur 1 est ainsi couramment appelé oscillateur RC, du fait que la tension Vref est disponible aux bornes de la résistance R et que les rampes Vc1 et Vc2 sont disponibles aux bornes des capacités respectives C1 et C2, ou, dit autrement, du fait que la fréquence des signaux cmd1 et cmd2 est déterminée par les valeurs de la résistance R et des capacités C1 et C2.

Toutefois, en pratique, le temps de propagation Tp des comparateurs n'est pas nul. Il en résulte que la commutation du signal cmd1, respectivement cmd2, ne se fait pas à l'instant t1, respectivement t2, où le signal Vc1, respectivement Vc2, atteint la valeur Vref, mais à un instant t1+Tp, respectivement t2+Tp, où la rampe Vc1, respectivement Vc2, est à une valeur maximale Vc1max, respectivement Vc2max, supérieure à la tension Vref. La fréquence des signaux cmd1 et cmd2 est alors égale à Ic/((2.C). (Vref + Ic.Tp/C)), ou, dit autrement, à un demi de 1/(R.C.(Iref/Ic + Tp/(R.C))).

Or, le temps de propagation Tp des comparateurs varie avec la température de l'oscillateur 1, d'où il résulte une variation de la fréquence des signaux cmd1 et cmd2 avec la température de l'oscillateur 1. A titre d'exemple, la fréquence des signaux cmd1 et cmd2 peut varier de +0.3% à - 40°C et de -1,4 % à 125°C par rapport à la fréquence à 30°C. De telles variations ne sont pas souhaitables, en particulier quand le signal cmd1 ou cmd2 est utilisé comme signal d'horloge ou pour générer un signal d'horloge.

Un oscillateur du type de celui décrit en relation avec la figure 1 est proposé ici, dans lequel, selon un mode de réalisation, la valeur d'une tension de consigne Vref' fournie au circuit COMP, par exemple aux comparateurs COMP1 et COMP2, est modulée, ou modifiée ou asservie, à partir de la valeur maximale d'au moins la dernière rampe Vc1 et/ou à partir de la valeur maximale d'au moins la dernière rampe Vc2. Dans ce cas, les tensions Vc1 et Vc2 sont comparées à la tension Vref' plutôt qu'à la tension Vref.

Dans la suite de la description, sauf indication contraire, l'expression "valeur maximale d'au moins la dernière rampe Vc1" signifie soit la valeur maximale Vc1max de la dernière rampe de tension Vc1, soit la valeur maximale moyennée, ou lissée ou filtrée, Vc1maxmean des valeurs maximales Vc1max de plusieurs dernières rampes de tension Vc1. De manière similaire, l'expression "valeur maximale d'au moins la dernière rampe Vc2" signifie soit la valeur maximale Vc2max de la dernière rampe de tension Vc2, soit la valeur maximale moyennée, ou lissée ou filtrée, Vc2maxmean des valeurs Vc2max de plusieurs dernières rampes de tension Vc2. Dans la suite, afin de ne pas surcharger la description, on appelle valeur maximale Vc1m, respectivement Vc2m, la valeur maximale d'au moins une dernière rampe de tension Vc1, respectivement Vc2. Dit autrement, la valeur maximale Vc1m, respectivement Vc2m, correspond soit à la valeur maximale Vc1max, respectivement Vc2max, de la dernière rampe de tension Vc1, respectivement Vc2, soit à la valeur maximale moyennée, ou lissée ou filtrée, Vc1maxmean, respectivement Vc2maxmean, des valeurs maximales Vc1max, respectivement Vc2max, de plusieurs dernières rampes de tension Vc1, respectivement Vc2.

Ainsi, une augmentation de la valeur Vc1m et/ou de la valeur Vc2m traduit une augmentation du temps de propagation Tp, et, à l'inverse, une diminution de la valeur Vc1m et/ou de la valeur Vc2m traduit une diminution du temps de propagation Tp.

Selon un mode de réalisation, la valeur de la tension de consigne Vref' diminue quand la valeur Vc1m et/ou la valeur Vc2m augmente, et, à l'inverse, augmente quand la valeur Vc2m et/ou la valeur Vc1m diminue. De préférence, la tension Vref' est inférieure à la tension Vref.

Selon un mode de réalisation, la tension de consigne Vref' fournie au circuit COMP, par exemple aux comparateurs COMP1 et COMP2, est égale à la tension de référence Vref à laquelle est soustrait un écart entre la tension de référence Vref et la valeur maximale Vc1m. Dit autrement, Vref'=Vref - (Vc1m - Vref).

Selon un autre mode de réalisation, la tension de consigne Vref' fournie au circuit COMP, par exemple aux comparateurs COMP1 et COMP2, est égale à la tension de référence Vref à laquelle est soustrait, de manière alternée, un écart entre la tension de référence Vref et la valeur maximale Vc1m, et un écart entre la tension de référence Vref et la valeur maximale Vc2m. Dit autrement, la tension Vref' est alternativement égale à Vref - (Vc1m - Vref) et à Vref - (Vc2m - Vref).

On tire ici profit du fait que la valeur maximale Vc1max de chaque rampe Vc1 et la valeur maximale Vc2max de chaque rampe Vc2 dépendent du temps de propagation Tp du circuit COMP, c'est-à-dire par exemple du temps de propagation Tp des comparateurs respectivement COMP1 et COMP2. Dit autrement, il est ici proposé d'asservir la tension de consigne Vref' fournie au circuit COMP, par exemple aux comparateurs COMP1 et COMP2, à partir de ce temps de propagation Tp.

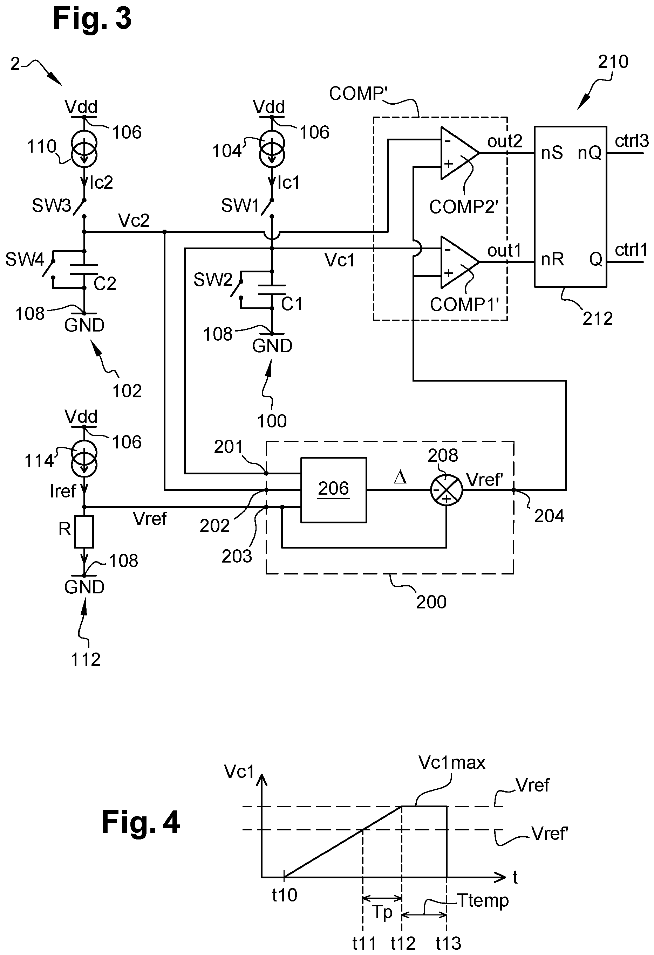

La figure 3 représente, de manière schématique et à l'aide de blocs fonctionnels, un mode de réalisation d'un tel oscillateur 2. L'oscillateur 2 comprend des éléments en commun avec l'oscillateur 1 qui ne seront pas décrits de nouveau.

En particulier, l'oscillateur 2 comprend, comme l'oscillateur 1, le générateur 100 de rampes de tension Vc1, le générateur 102 de rampes de tension Vc2 et le générateur 112 de la tension Vref, les générateurs 100, 102 et 112 étant, par exemple, identiques à ceux décrits en relation avec la figure 1.

Toutefois, à la différence de l'oscillateur 1 dans lequel le circuit COMP est configuré pour comparer chaque rampe de tension Vc1, Vc2 à la tension Vref, dans ce mode de réalisation, un circuit COMP', par exemple identique au circuit COMP, est configuré pour comparer chaque rampe de tension Vc1, Vc2 à la tension de consigne Vref'. Comme le circuit COMP, le circuit COMP' est configuré pour fournir un signal binaire out1 dont l'état haut ou bas indique le résultat de la comparaison de la tension Vc1 avec la tension Vref', et pour fournir un signal binaire out2 dont l'état haut ou bas indique le résultat de la comparaison de la tension Vc2 avec la tension Vref'. Le circuit COMP' comprend par exemple trois entrées recevant les tensions respectives Vref', Vc1 et Vc2.

Le circuit COMP' comprend par exemple un comparateur COMP1', par exemple identique au comparateur COMP1, et un comparateur COMP2', par exemple identique au comparateur COMP2. Le comparateur COMP1' est configuré pour comparer chaque rampe de tension Vc1 à la tension de consigne Vref' et pour fournir le signal out1. Le comparateur COMP2' est configuré pour comparer chaque rampe de tension Vc2 à la tension Vref' pour fournir le signal out2. Dans cet exemple, l'entrée inverseuse (-) du comparateur COMP1' reçoit la tension Vc1, l'entrée non inverseuse (+) du comparateur COMP1' reçoit la tension Vref', l'entrée inverseuse (-) du comparateur COMP2' reçoit la tension Vc2, et l'entrée non inverseuse (+) du comparateur COMP1' reçoit la tension Vref'.

En outre, par rapport à l'oscillateur 1, l'oscillateur 2 comprend un circuit 200 configuré pour fournir, ou générer, la tension Vref'.

Dans le mode de réalisation illustré en figure 3, le circuit 200 est configuré pour moduler la tension Vref' sur la base de la valeur maximale Vc1m et de la valeur maximale Vc2m. Ainsi, dans ce mode de réalisation, le circuit 200 comprend une borne d'entrée 201 reliée, par exemple connectée, au générateur 100, par exemple à une borne de sortie du générateur 100 sur laquelle est disponible la tension Vc1, et une borne d'entrée 202 reliée, par exemple connectée, au générateur 102, par exemple à une borne de sortie du générateur 102 sur laquelle est disponible la tension Vc2. Le circuit 200 est alors configuré pour déterminer les valeurs Vc1m et Vc2m à partir des tensions respectives Vc1 et Vc2.

Dans une variante de réalisation non illustrée où le circuit 200 est configuré pour moduler la tension Vref' uniquement sur la base de la valeur maximale Vc1m ou uniquement sur la base de la valeur maximale Vc2m, l'entrée 202 ou 201 respectivement peut être omise.

Le circuit 200 comprend en outre une borne d'entrée 203 reliée, par exemple connectée, au générateur 112, par exemple à une borne de sortie du générateur 112 sur laquelle est disponible la tension de référence Vref.

Le circuit 200 comprend en outre une borne de sortie 204 sur laquelle est disponible la tension modulée Vref'.

Dans ce mode de réalisation, le circuit 200 est configuré pour générer, à partir des tensions Vref, Vc1 et Vc2, un signal Δ représentatif, alternativement, de l'écart entre la tension Vref et la valeur maximale Vc1m, et de l'écart entre la tension Vref et la valeur maximale Vc2m. Cette fonctionnalité du circuit 200 est mise en œuvre par un bloc fonctionnel 206. Le circuit 200 est en outre configuré pour fournir la tension Vref' de sorte qu'elle soit égale à la tension Vref moins, alternativement, l'écart entre la tension Vref et la valeur maximale Vc1m, et l'écart entre la tension Vref et la valeur maximale Vc2m. Cette fonctionnalité du circuit 200 est illustrée par un bloc soustracteur 208 prenant en entrée le signal Δ et la tension Vref et fournissant en sortie la tension Vref'.

Dans une variante de réalisation non illustrée, le circuit 200 est configuré pour moduler la tension Vref' uniquement sur la base de la valeur maximale Vc1m ou Vc2m. Le bloc ou circuit 206 est alors configuré pour fournir le signal Δ de sorte qu'il soit représentatif de l'écart entre la tension Vref et la valeur maximale respectivement Vc1m ou Vc2m. En outre, le circuit 200 est alors configuré pour fournir la tension Vref' de sorte qu'elle soit égale à la tension Vref moins cet écart.

De préférence, dans le mode de réalisation illustré en figure 3, la valeur maximale Vc1m, respectivement Vc2m, correspond à la valeur Vc1maxmean, respectivement Vc2maxmean. Dans ce cas, le bloc ou circuit 206 est de préférence configuré pour mettre à jour et mémoriser un premier signal Vc1-sig (non représenté en figure 3) représentatif de la valeur Vc1maxmean et pour mettre à jour et mémoriser un deuxième signal Vc2-sig (non représenté en figure 3) représentatif de la valeur maximale Vc2maxmean. Le signal Δ est alors déterminé à partir de ces signaux Vc1-sig et Vc2-sig. De préférence, le signal Δ est alternativement déterminé à partir du signal Vc1-sig et à partir du signal Vc2-sig.

L'oscillateur 2 comprend en outre un circuit de commande 210, partiellement représenté en figure 3. Sur la base des signaux out1 et out2, le circuit de commande 210 est configuré pour :
arrêter une rampe de tension Vc1 et démarrer une rampe de tension Vc2 quand la rampe de tension Vc1 atteint la tension Vref', et
arrêter une rampe de tension Vc2 et démarrer une rampe de tension Vc1 quand la rampe de tension Vc2 atteint la tension Vref'.

Selon un mode de réalisation, une rampe de tension Vc1 est arrêtée en commutant l'interrupteur SW1 à l'état ouvert, et une rampe de tension Vc2 est arrêtée en commutant l'interrupteur SW3 à l'état ouvert. A l'inverse, une rampe de tension Vc1 débute quand l'interrupteur SW1 commute à l'état fermé, et une rampe de tension Vc2 débute quand l'interrupteur SW3 commute à l'état fermé. A titre d'exemple, le circuit de commande 210 comprend un verrou RS 212 ayant une entrée nS recevant le signal out2, une entrée nR recevant le signal out1, une sortie nQ fournissant un signal ctrl3 de commande de l'interrupteur SW3, et une sortie Q fournissant un signal ctrl1 de commande de l'interrupteur SW1. Dans cet exemple, le verrou RS est configuré pour :
- mettre le signal ctrl3 à l'état haut et le signal ctrl1 à l'état bas quand le signal out1 commute à l'état bas alors que le signal out2 est à l'état haut, et
- mettre le signal ctrl1 à l'état haut et le signal ctrl3 à l'état bas quand le signal out2 commute à l'état bas alors que le signal out1 est à l'état haut. Dans cet exemple, les interrupteurs SW1 et SW3 sont ouverts quand leurs signaux de commande respectifs sont à l'état bas, et fermés quand leurs signaux de commande respectifs sont à l'état haut.

Selon un mode de réalisation, le circuit de commande 210 est en outre configuré, sur la base des signaux out1 et out2, pour réinitialiser le générateur 100 entre chaque deux rampes de tension Vc1 successives, et pour réinitialiser le générateur 102 entre chaque deux rampes de tension Vc2 successives. La réinitialisation du générateur 100, respectivement 102, consiste à remettre la tension Vc1, respectivement Vc2, à une valeur initiale, c'est-à-dire la valeur qu'a la tension Vc1, respectivement Vc2, au début d'une rampe.

Selon un mode de réalisation, la réinitialisation du générateur 100, respectivement 102, est mise en œuvre en fermant puis en ouvrant l'interrupteur SW2, respectivement SW4.

Selon un mode de réalisation, le circuit de commande 210 est configuré pour que la réinitialisation du générateur 100, respectivement 102, intervienne à la fin d'une période de temporisation Ttemp débutant à l'arrêt, ou fin, d'une rampe Vc1, respectivement Vc2, la période de temporisation Ttemp étant suffisamment courte pour que le générateur 100, respectivement 102, soit réinitialisé avant le début de la prochaine rampe Vc1, respectivement Vc2. Ainsi, pour chaque rampe de tension Vc1, respectivement Vc2, la tension Vc1, respectivement Vc2, reste à sa valeur maximale Vc1max, respectivement Vc2max pendant toute la durée de temporisation Ttemp. Cela permet que le circuit 200 puisse lire cette valeur maximale pendant la durée de temporisation Ttemp, et donc mettre à jour le signal Vc1-sig ou Vc2-sig pendant cette durée Ttemp.

La mise en œuvre du circuit de commande 210 pour qu'il génère, à partir des signaux out1 et out2, voire par exemple à partir des signaux ctrl3 et ctrl1, les signaux de commande de réinitialisation des générateurs 100 et 102 est à la portée de la personne du métier à partir des indications fonctionnelles données ci-dessus.

De préférence, lorsque le bloc 206 est configuré pour mettre à jour et mémoriser le signal Vc1-sig et/ou pour mettre à jour et mémoriser le signal Vc2-sig, le circuit de commande 210 est en outre configuré pour fournir les signaux de commande de ces phases de mise à jour et de mémorisation. Dans ce cas, bien que cela ne soit pas représenté en figure 3, le circuit 200 comprend des bornes d'entrée configurées pour recevoir ces signaux de commande provenant du circuit 210.

La mise en œuvre du circuit de commande 210 pour qu'il génère, à partir des signaux out1 et out2, voire par exemple à partir des signaux ctrl3 et ctrl1, les signaux de commande du circuit 200 est à la portée de la personne du métier à partir des indications fonctionnelles données ci-dessus.

Selon un mode de réalisation, l'oscillateur 2 est utilisé pour générer un signal d'horloge. Ce signal d'horloge peut alors correspondre au signal out1, au signal out2, au signal ctrl3 ou au signal ctrl1. Toutefois, en raison de la nature impulsionnelle des signaux out1 et out2, le signal d'horloge est de préférence obtenu après mis en forme du signal out1 et/ou out2, ce signal mis en forme étant par exemple le signal ctrl1 ou ctrl3.

La figure 4 représente un chronogramme d'une rampe de tension Vc1 illustrant le fonctionnement de l'oscillateur 2 de la figure 3.

Avant un instant t10, le générateur 100 a été réinitialisé et la tension Vc1 est à une valeur initiale, à savoir 0V dans cet exemple où les rampes Vc1 sont croissantes.

A l'instant t10, une rampe de tension Vc1 débute.

A un instant suivant t11, la tension Vc1 atteint (croise) la tension Vref'. Toutefois, la sortie out1 (non représentée en figure 4) du comparateur COMP1' (figure 3) ne bascule qu'à un instant t12 suivant égal à t11+Tp. Dit autrement, la sortie out1 du comparateur COMP1' commute avec un retard Tp par rapport à l'instant t11, le retard Tp correspondant au temps de propagation dans le comparateur COMP1'.

Du fait qu'entre les instants t11 et t12, à cause du temps de propagation Tp dans le comparateur COMP1', la sortie out1 du comparateur COMP1' reste à un état indiquant que la rampe de tension Vc1 n'a pas encore atteint la tension Vref', le circuit de commande 210 ne commande pas l'arrêt de la rampe de tension Vc1 par le générateur 100. Ainsi, dans cet exemple où les rampes Vc1 sont croissantes, la rampe Vc1 continue de croître jusqu'à l'instant t12.

A l'instant t12, la sortie out1 du comparateur COMP1' commute, d'où il résulte que le circuit 210 commande l'arrêt de la rampe de tension Vc1. La rampe de tension Vc1 atteint donc sa valeur maximale Vc1max à l'instant t12, et cette valeur maximale Vc1max est alors égale à la tension Vref. Dit autrement, la sortie out1 commute à l'instant où la tension Vc1 atteint la tension de consigne Vref, comme si le comparateur COMP1' avait comparé la tension Vc1 avec la tension Vref et avait un temps de propagation Tp nul.

Il en résulte que la fréquence des signaux out1 et out2 de l'oscillateur 2 est égale à la fréquence des signaux out1 et out2 de l'oscillateur 1 dans le cas idéal où le temps de propagation Tp dans le circuit COMP, par exemple dans les comparateurs COMP1 et COMP2, de l'oscillateur 1 est nul.

Dans l'exemple de la figure 4, après l'instant t12, la tension Vc1 reste à sa valeur maximale Vc1max jusqu'à un instant t13 égal à t12+Ttemp. Ainsi, entre les instants t12 et t13, la valeur maximale Vc1max de la rampe de tension Vc1 est disponible pour le circuit 200. A l'instant t13, le générateur 100 est réinitialisé, par exemple sous le contrôle du circuit 210, et la tension Vc1 est remise à sa valeur initiale, d'où il résulte que le signal out1 commute.

Bien que cela ne soit pas représenté en figure 4, l'instant t10 correspond à la fin d'une rampe de tension Vc2, et l'instant t12 correspond au début d'une nouvelle rampe de tension Vc2.

Bien qu'il ne soit pas illustré, le fonctionnement de l'oscillateur 2 lors d'une rampe de tension Vc2 se déduit du fonctionnement de l'oscillateur 2 lors d'une rampe de tension Vc1 tel que décrit en relation avec la figure 4. On notera toutefois que, dans une variante de réalisation non illustrée où le circuit 200 est configuré pour moduler la tension Vref' uniquement sur la base de la valeur maximale Vc1m, respectivement Vc2m, la durée de temporisation Ttemp pour la réinitialisation du générateur 102, respectivement 100, peut être nulle.

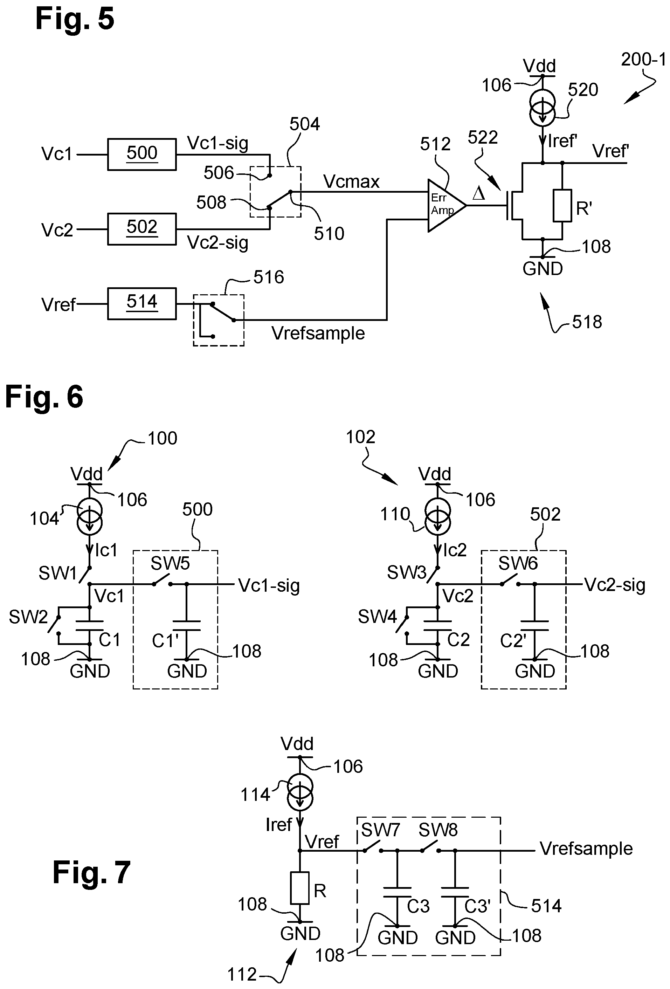

La figure 5 représente de manière plus détaillée un mode de réalisation d'une partie de l'oscillateur 2 de la figure 3, et plus particulièrement, un exemple de mode de réalisation du circuit 200 de la figure 3, ce circuit étant ici référencé 200-1. On notera que tout ce qui a été indiqué pour le circuit 200 de la figure 3 s'applique au circuit 200-1 de la figure 5.

Dans ce mode de réalisation, le circuit 200-1 est configuré pour moduler la tension Vref' sur la base de la valeur maximale Vc1m et de la valeur maximale Vc2m. Dit autrement, le signal Δ est déterminé, de préférence alternativement, à partir du signal Vc1-sig et à partir du signal Vc2-sig.

Plus particulièrement, dans ce mode de réalisation, le circuit 200 est configuré pour mettre à jour et mémoriser le premier signal Vc1-sig représentatif de la valeur maximale Vc1m, et pour mettre à jour et mémoriser le deuxième signal Vc2-sig représentatif de la valeur maximale Vc2m.

Dans ce mode de réalisation, le circuit 200-1 comprend un circuit 500 configuré pour générer le signal Vc1-sig, en pratique une tension, à partir de la tension Vc1. Le circuit 500 comprend donc une entrée configurée pour recevoir la tension Vc1 et une sortie configurée pour fournir le signal Vc1-sig. Plus particulièrement, à la fin de chaque rampe de tension Vc1, pendant la période de temporisation Ttemp, le circuit 500 est configuré pour mettre jour le signal Vc1-sig à partir de la valeur maximale Vc1max de cette rampe de tension Vc1, puis pour mémoriser le signal Vc1-sig mis à jour.

De manière similaire, le circuit 200-1 comprend un circuit 502 configuré pour générer le signal Vc2-sig, en pratique une tension, à partir de la tension Vc2. Le circuit 502 comprend donc une entrée configurée pour recevoir la tension Vc2 et une sortie configurée pour fournir le signal Vc2-sig. Plus particulièrement, à la fin de chaque rampe de tension Vc2, pendant la période de temporisation Ttemp, le circuit 502 est configuré pour mettre jour le signal Vc2-sig à partir de la valeur maximale Vc2max de cette rampe de tension Vc2, puis pour mémoriser le signal Vc2-sig mis à jour.

De préférence, les phases de mise à jour et de mémorisation des signaux Vc1-sig et Vc2-sig sont contrôlées par des signaux de commande provenant du circuit de commande 210 (figure 3), les circuits 500 et 502 comprenant alors des bornes d'entrée configurées pour recevoir ces signaux de commande, ces bornes d'entrée n'étant pas représentées en figure 5.

Le circuit 200-1 comprend en outre un commutateur 504 comprenant une entrée 506 configurée pour recevoir le signal Vc1-sig, une entrée 508 configurée pour recevoir le signal Vc2-sig, et une sortie 510 configurée pour fournir un signal, par exemple une tension, Vcmax égal au signal Vc1-sig quand un signal de commande (non représenté) du commutateur 504 est dans un premier état binaire, et au signal Vc2-sig quand le signal de commande du commutateur 504 est dans un deuxième état binaire. Ainsi, le signal Vcmax est alternativement égal au signal Vc1-sig et au signal Vc2-sig. De préférence, le signal de commande du commutateur 504 est fourni par le circuit de commande 210 (figure 3).

Le circuit 200 comprend en outre un amplificateur d'erreur 512 ("Err Amp") configuré pour fournir le signal Δ. L'amplificateur d'erreur 512 comprend une entrée configurée pour recevoir le signal Vcmax, cette entrée de l'amplificateur d'erreur 512 étant reliée, par exemple connectée, à la sortie 510 du commutateur 504. L'amplificateur 512 comprend en outre une autre entrée configurée pour recevoir un signal Vrefsample représentatif de la tension Vref, c'est-à-dire déterminé par la tension Vref.

Dans le mode de réalisation de la figure 5, le circuit 200 comprend un circuit 514 optionnel configuré pour générer le signal Vrefsample à partir de la tension Vref. Le circuit 514 comprend donc une entrée configurée pour recevoir la tension Vref et une sortie configurée pour fournir le signal Vrefsample. De préférence, à la fin de chaque rampe de tension Vc1 ou à la fin de chaque rampe Vc2, pendant la période de temporisation Ttemp, le circuit 514 est configuré pour mettre à jour le signal Vrefsample à partir de la tension Vref, puis pour mémoriser le signal Vrefsample mis à jour. Le fonctionnement du circuit 514 et la mise en œuvre du circuit 514 sont par exemple similaires à ceux des circuits 500 et 502.

Dans le mode de réalisation de la figure 5, la sortie du circuit 514 est reliée à l'entrée de l'amplificateur d'erreur 512 configurée pour recevoir le signal Vrefsample par l'intermédiaire d'un commutateur 516 optionnel, de préférence identique au commutateur 504. Le commutateur 516 comprend deux entrées toutes deux reliées, de préférence connectées, à la sortie du circuit 514, et une sortie reliée à ladite entrée de l'amplificateur d'erreur 512. De préférence, le commutateur 516 est commandé de manière identique que le commutateur 504, par exemple par le même signal de commande. Comme on le verra plus en détail dans la suite, la prévision du commutateur 516 permet que les mêmes injections de charges se produisent sur le signal Vcmax et sur le signal Vrefsample, de sorte que ces injections de charges s'annulent au niveau de l'amplificateur d'erreur 512.

Selon un mode de réalisation, chaque circuit 500, 502 et 514 mémorise le signal respectivement Vc1-sig, Vc2-sig et Vrefsample aux bornes d'une capacité reliée à l'entrée de ce circuit par un interrupteur comme cela sera décrit plus en détail en relation avec les figures 6 et 7. Lors de leurs commutations, ces interrupteurs peuvent injecter des charges sur les capacités auxquelles ils sont reliés. La prévision du circuit 514 permet que les mêmes injections de charges se produisent sur le signal de sortie du circuit 514, et sur les signaux Vc1-sig et Vc2-sig. Ainsi, les injections de charges dans les circuits 500, 502 et 514 s'annulent dans le signal Δ, du fait que ce signal Δ est un signal différentiel représentatif de la différence entre les signaux Vcmax et Vrefsample. De manière similaire, les commutations du commutateur 504 peuvent injecter des charges sur le signal Vcmax. La prévision du commutateur 516 permet que les mêmes injections de charges se produisent sur le signal Vcmax et sur le signal Vrefsample, et s'annulent dans le signal Δ.

Dans une variante de réalisation non illustrée, le commutateur 516 et le circuit 514 sont omis, le signal Vrefsample étant alors identique au signal Vref, ou, dit autrement, confondu avec le signal Vref. Dans une autre variante de réalisation non illustrée, seul le commutateur 516 est omis, la sortie du circuit 514 fournissant alors le signal Vrefsample et étant, par exemple, connectée à l'entrée correspondante de l'amplificateur d'erreur 512.

Les circuits 500 et 502, le circuit optionnel 514, le commutateur 504, le commutateur optionnel 516 et l'amplificateur d'erreur 512 mettent en œuvre les fonctions du bloc ou circuit 206 décrit en relation avec la figure 3.

Dans le mode de réalisation de la figure 5, le circuit 200 comprend un générateur de tension 518 configuré pour fournir la tension Vref', le générateur 518 étant commandé par le signal Δ. Le générateur 518 met en œuvre la fonction du bloc soustracteur 208 décrit en relation avec la figure 3.

A titre d'exemple, le générateur 518 comprend, comme le générateur 112 décrit en relation avec la figure 3, une source de courant 520 configurée pour délivrer un courant constant Iref', de préférence égal au courant Iref (figure 3), et une résistance R', de préférence identique à la résistance R (figure 3). La source de courant 520 et la résistance R' sont connectées en série entre les noeuds 106 et 108. Le générateur 518 comprend en outre un transistor MOS (métal oxyde semiconducteur - "Metal Oxide Semiconductor") 522 connecté en parallèle de la résistance R', la grille du transistor 522 recevant le signal Δ. Ainsi, lorsque l'écart entre la tension Vref et les valeurs maximales Vc1m et Vc2m augmente, le signal Δ augmente ce qui permet de réduire la résistance équivalente correspondant à l'association en parallèle de la résistance R' et du transistor 522, d'où il résulte une diminution de la tension Vref'.

On a décrit ci-dessus en relation avec la figure 5 un exemple de mode de réalisation du circuit 200-1 dans le cas où le circuit 200-1 est configuré pour moduler la tension Vref' sur la base de la valeur maximale Vc1m et sur la base de la valeur maximale Vc2m.

Dans une variante de réalisation non illustrée, le circuit 200-1 est configuré pour moduler la tension Vref' uniquement sur la base de la valeur maximale Vc1m. Dans cette variante, le commutateur 504, le circuit 502 et le commutateur 516 optionnel sont omis. Le signal Vcmax est alors identique au signal Vc1-sig, c'est-à-dire confondu avec le signal Vc1-sig. Dans une autre variante de réalisation non illustrée, le circuit 200 est configuré pour moduler la tension Vref' uniquement sur la base de la valeur maximale Vc2m. Dans cette autre variante, le commutateur 504, le circuit 500 et le commutateur 516 optionnel sont omis. Le signal Vcmax est alors identique au signal Vc2-sig, c'est-à-dire confondu avec le signal Vc2-sig.

La figure 6 représente de manière plus détaillée un mode de réalisation d'une partie de l'oscillateur 2 de la figure 3. Plus exactement, la figure 6 représente de manière plus détaillée un mode de réalisation des circuits 500 et 502 décrits en relation avec la figure 5, le circuit 500, respectivement 502, étant ici connecté au générateur 100, respectivement 102, de l'oscillateur 2.

Le circuit 500 comprend une association en série d'une capacité C1' et d'un interrupteur SW5, connectée en parallèle de la capacité C1, l'interrupteur SW5 étant connecté à une borne de la capacité C1 sur laquelle est disponible la tension Vc1. Dit autrement, l'interrupteur SW5 relie la sortie du générateur 100 à une première borne de la capacité C1', la deuxième borne de la capacité C1' étant reliée, de préférence connectée, au noeud 108. La capacité C1' est de préférence identique à la capacité C1. Le signal Vc1-sig correspond à la tension aux bornes de la capacité C1', ou, dit autrement, la tension Vc1-sig est disponible sur la première borne de la capacité C1' qui constitue alors la sortie du circuit 500. La tension Vc1-sig est mise à jour à partir de la tension Vc1 en fermant l'interrupteur SW5, et est mémorisée aux bornes de la capacité C1' en ouvrant l'interrupteur SW5. De préférence, le signal de commande de l'interrupteur SW5 est fourni par le circuit de commande 210 (figure 3). De préférence, après chaque rampe de tension Vc1, l'interrupteur SW5 est commuté à l'état fermé pendant la période de temporisation Ttemp suivant l'arrêt de la rampe, et est ensuite commuté à l'état ouvert à la fin de cette période Ttemp.

De manière similaire, le circuit 502 comprend une association en série d'une capacité C2' et d'un interrupteur SW6, connectée en parallèle de la capacité C2, l'interrupteur SW6 étant connecté à une borne de la capacité C2 sur laquelle est disponible la tension Vc2. Dit autrement, l'interrupteur SW6 relie la sortie du générateur 102 à une première borne de la capacité C2', la deuxième borne de la capacité C2' étant reliée, de préférence connectée, au noeud 108. La capacité C2' est de préférence identique à la capacité C2. Le signal Vc2-sig correspond à la tension aux bornes de la capacité C2', ou, dit autrement, la tension Vc2-sig est disponible sur la première borne de la capacité C2' qui constitue alors la sortie du circuit 502. La tension Vc2-sig est mise à jour à partir de la tension Vc2 en fermant l'interrupteur SW6, et est mémorisée aux bornes de la capacité C2' en ouvrant l'interrupteur SW6. De préférence, le signal de commande de l'interrupteur SW6 est fourni par le circuit de commande 210 (figure 3). De préférence, après chaque rampe de tension Vc2, l'interrupteur SW6 est commuté à l'état fermé pendant la période de temporisation Ttemp suivant l'arrêt de la rampe, et est ensuite commuté à l'état ouvert à la fin de cette période Ttemp.

La mise en œuvre du circuit 210 (figure 3) pour fournir les signaux de commande des interrupteurs SW5 et SW6, à partir des signaux out1 et out2 (figure 3), est à la portée de la personne du métier à partir des indications fonctionnelles données ci-dessus.

Dans une variante de réalisation non illustrée, le générateur 100 comprend un interrupteur supplémentaire connecté en parallèle de l'association en série de l'interrupteur SW1 et de la capacité C1, cet interrupteur supplémentaire étant, par exemple, commandé comme l'interrupteur SW2. Cet interrupteur supplémentaire permet de relier la source de courant 104 au noeud 108 lorsque l'interrupteur SW1 est ouvert afin de réduire, voire supprimer, d'éventuels phénomènes transitoires sur la borne de la source de courant 104 reliée à l'interrupteur SW1. De manière symétrique, dans cette variante, le générateur 102 comprend un interrupteur supplémentaire connecté en parallèle de l'association en série de l'interrupteur SW3 et de la capacité C2, cet interrupteur supplémentaire étant, par exemple, commandé comme l'interrupteur SW4.

La figure 7 représente de manière plus détaillée un mode de réalisation d'une partie de l'oscillateur 2 de la figure 3. Plus exactement, la figure 7 représente de manière plus détaillée un mode de réalisation du circuit 514 décrit en relation avec la figure 5, le circuit 514 étant ici connecté au générateur 112 de l'oscillateur 2.

Le circuit 514 comprend une capacité C3 et un interrupteur SW7 reliant la sortie du générateur 112, c'est-à-dire un noeud de fourniture de la tension Vref, à une première borne de la capacité C3, la deuxième borne de la capacité C3 étant reliée, de préférence connectée, au noeud 108. Le circuit 514 comprend une capacité C3', de préférence identique à la capacité C3, et un interrupteur SW8 reliant la première borne de la capacité C3, c'est-à-dire le noeud de connexion entre la capacité C3 et l'interrupteur SW7, à une première borne de la capacité C3', la deuxième borne de la capacité C3' étant reliée, de préférence connectée, au noeud 108. La tension Vrefsample est disponible sur la première borne de la capacité C3', qui constitue la sortie du circuit 514.

De préférence, les signaux de commande des interrupteurs SW7 et SW8 sont fournis par le circuit de commande 210 (figure 3), à partir des signaux out1 et out2. A titre d'exemple, l'interrupteur SW7 est commandé comme l'interrupteur SW1 (figure 6), et l'interrupteur SW8 est alors commandé comme l'interrupteur SW5 (figure 6). Ainsi, les injections de charges sur la capacité C3' en raison des commutations des interrupteurs SW7 et SW8 sont identiques aux injections de charges sur la capacité C1' (figure 6) en raison des commutations des interrupteurs SW1 et SW5. Selon un autre exemple, les interrupteurs SW7 et SW8 sont commandés de la même façon que les interrupteurs respectifs SW3 et SW6 (figure 6), les injections de charges sur la capacité C3' en raison des commutations des interrupteurs SW7 et SW8 étant alors identiques aux injections de charges sur la capacité C2' (figure 6) en raison des commutations des interrupteurs SW3 et SW6.

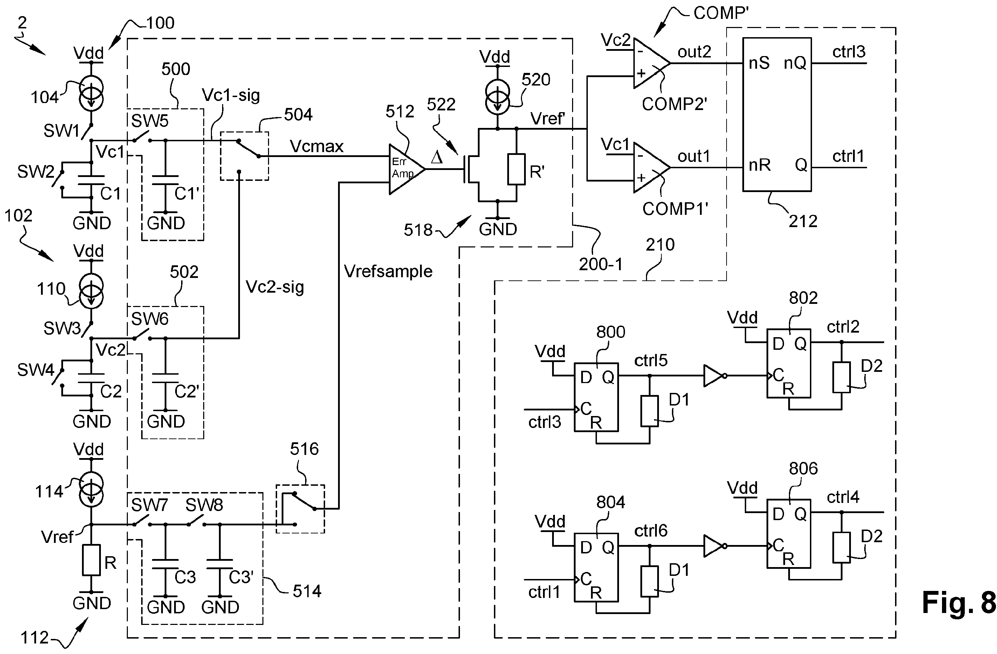

La figure 8 représente de manière plus détaillée un mode de réalisation de l'oscillateur 2 de la figure 3. Plus exactement, en figure 8, le circuit 200 de l'oscillateur 2 est mis en œuvre par le circuit 200-1 de la figure 5, les circuits 500 et 502 étant mis en œuvre de la façon illustrée en figure 6 et le circuit 514 étant mis en œuvre de la façon illustrée en figure 7. En outre, en figure 8, un exemple de mode de réalisation du circuit 210 est détaillé.

Dans cet exemple de mode de réalisation détaillé, on considère que les interrupteurs SW1, SW2, SW3, SW4, SW5, SW6, SW7 et SW8 sont fermés, respectivement ouverts, quand leurs signaux de commande respectifs sont à l'état haut, respectivement bas.

Le circuit de commande 210 comprend le verrou 212 tel que décrit en relation avec la figure 3. Dans cet exemple, comme en figure 3, le signal ctrl1 est le signal de commande de l'interrupteur SW1 et le signal ctrl3 est le signal de commande de l'interrupteur SW3.

Dans cet exemple, le circuit de commande 210 comprend en outre une bascule D ("D flip flop") 800. La bascule 800 comprend une entrée de donnée D recevant le potentiel Vdd, une entrée de synchronisation C active sur front montant et recevant le signal ctrl3, une sortie Q sur laquelle est recopié et mémorisé le potentiel Vdd à chaque front montant du signal ctrl3, et une entrée R. La sortie Q de la bascule 800 est remise au potentiel GND quand le signal appliqué à l'entrée R de la bascule est à l'état haut. La sortie Q de la bascule 800 est reliée à l'entrée R de la bascule 800 par un circuit D1 introduisant un retard égal à la durée Ttemp. Un signal ctrl5 de commande de l'interrupteur SW5 est disponible sur la sortie Q de la bascule 800, ce signal étant fourni à l'entrée R de la bascule avec le retard Ttemp par le circuit D1.

Dans cet exemple, le circuit 210 comprend en outre une bascule D 802, identique à la bascule 800. L'entrée C de la bascule 802 est reliée à la sortie Q de la bascule 800 par un inverseur. Dit autrement, l'entrée C de la bascule 802 reçoit l'inverse du signal ctrl5. L'entrée D de la bascule 802 reçoit le potentiel Vdd. Un signal ctrl2 de commande de l'interrupteur SW2 est disponible sur la sortie Q de la bascule 802, ce signal étant fourni à l'entrée R de la bascule 802 avec un retard introduit par un circuit D2 reliant la sortie Q et l'entrée R de la bascule 802.

Ainsi, lorsqu'une rampe de tension Vc1 croise la tension Vref' en provoquant la commutation à l'état bas du signal out1, le signal ctrl3 commute à l'état haut, d'où il résulte la fermeture de l'interrupteur SW3 et le début d'une rampe Vc2, et le signal ctrl1 commute à l'état bas, d'où il résulte l'ouverture de l'interrupteur SW1 et la fin de la rampe Vc1. Le front montant sur le signal ctrl3 entraîne en outre la commutation du signal ctrl5 à l'état haut et la fermeture de l'interrupteur SW5 (mise à jour de la tension Vc1max). Le signal ctrl5 reste à l'état haut pendant toute la durée Ttemp, jusqu'à ce que le front montant du signal ctrl5 soit transmis à l'entrée R de la bascule 800 par le circuit D1, ce qui entraîne la commutation du signal ctrl5 à l'état bas et l'ouverture de l'interrupteur SW5 (mémorisation de la tension Vc1max). La commutation du signal ctrl5 à l'état bas entraîne l'application d'un front montant sur l'entrée C de la bascule 802, d'où il résulte la commutation du signal ctrl2 à l'état haut et la fermeture de l'interrupteur SW2 (réinitialisation de la tension Vc1). Le signal ctrl2 reste à l'état haut jusqu'à ce que le front montant du signal ctrl2 soit transmis à l'entrée R de la bascule 802 par le circuit D2, ce qui entraîne la commutation du signal ctrl2 à l'état bas et l'ouverture de l'interrupteur SW2.

Dans cet exemple, le circuit de commande 210 comprend en outre une bascule D ("D flip flop") 804, identique aux bascules 800 et 804. La bascule 804 comprend une entrée de donnée D recevant le potentiel Vdd, une entrée de synchronisation C recevant le signal ctrl1 et une sortie Q fournissant un signal ctrl6 de commande de l'interrupteur SW6. La sortie Q de la bascule 804 est reliée à une entrée R de la bascule 804 par un circuit D1 introduisant un retard égal à la durée Ttemp.

Dans cet exemple, le circuit 210 comprend en outre une bascule D 806, identique à la bascule 800. L'entrée C de la bascule 806 est reliée à la sortie Q de la bascule 804 par un inverseur. Dit autrement, l'entrée C de la bascule 806 reçoit l'inverse du signal ctrl6. L'entrée D de la bascule 806 reçoit le potentiel Vdd. Un signal ctrl4 de commande de l'interrupteur SW4 est disponible sur la sortie Q de la bascule 806, ce signal étant fourni à l'entrée R de la bascule 806 avec un retard introduit par un circuit D2 reliant la sortie Q et l'entrée R de la bascule 806.

Ainsi, lorsqu'une rampe de tension Vc2 croise la tension Vref' en provoquant la commutation à l'état bas du signal out2, le signal ctrl1 commute à l'état haut, d'où il résulte la fermeture de l'interrupteur SW1 et le début d'une rampe Vc1, et le signal ctrl3 commute à l'état bas, d'où il résulte l'ouverture de l'interrupteur SW3 et la fin de la rampe Vc2. Le front montant sur le signal ctrl1 entraîne en outre la commutation du signal ctrl6 à l'état haut et la fermeture de l'interrupteur SW6 (mise à jour de la tension Vc2max). Le signal ctrl6 reste à l'état haut pendant toute la durée Ttemp, jusqu'à ce que le front montant du signal ctrl6 soit transmis à l'entrée R de la bascule 804 par le circuit D1, ce qui entraîne la commutation du signal ctrl6 à l'état bas et l'ouverture de l'interrupteur SW6 (mémorisation de la tension Vc2max). La commutation du signal ctrl6 à l'état bas entraîne l'application d'un front montant sur l'entrée C de la bascule 806, d'où il résulte la commutation du signal ctrl4 à l'état haut et la fermeture de l'interrupteur SW4 (réinitialisation de la tension Vc2). Le signal ctrl4 reste à l'état haut jusqu'à ce que le front montant du signal ctrl4 soit transmis à l'entrée R de la bascule 806 par le circuit D2, ce qui entraîne la commutation du signal ctrl4 à l'état bas et l'ouverture de l'interrupteur SW4.

La personne du métier est en mesure de choisir une fréquence de commutation du commutateur 504 et de l'éventuel commutateur 516, et de mettre en œuvre la génération des signaux de commande de ces commutateurs par le circuit 210. A titre d'exemple, le signal de commande de chacun des commutateurs 504 et 516 est commuté à chaque début de rampe Vc1 et Vc2, par exemple de manière que pendant chaque rampe de tension Vc1, le signal Vcmax soit égal au signal Vc2max et que pendant chaque rampe de tension Vc2, le signal Vcmax soit égal au signal Vc1max. A titre d'autre exemple, le commutateur 504 et l'éventuel commutateur 516 sont commutés sur des divisions entières d'un signal d'horloge obtenu à partir de l'oscillateur 2, ce qui permet que le signal Vcmax soit représentatif d'une moyenne entre les signaux Vc1-sig et Vc2-sig, le signal Vcmax prenant alternativement la valeur du signal Vc1-sig et la valeur du signal Vc2-sig à la fréquence de commutation des commutateurs 504 et 516.

Dans l'exemple de la figure 8, les interrupteurs SW7 et SW8 sont par exemple commandés de manière identique aux interrupteurs respectifs SW1 et SW3. Dans d'autres exemples non illustrés, les interrupteurs peuvent être commandés de manière identique aux interrupteurs respectivement SW1 et SW5 lorsque le commutateur 504 est dans un premier état où le signal Vcmax est égal au signal Vc1-sig, et de manière identique aux interrupteurs respectivement SW3 et SW6 lorsque le commutateur est dans un deuxième état où le signal Vcmax est égal au signal Vc2-sig.

La personne du métier est en mesure de sélectionner la valeur de la durée Ttemp et celle du retard introduit par chacun des circuits D2 pour que la succession d'une phase de mise à jour de la tension Vc1max, respectivement Vc2max, de mémorisation de la tension Vc1max, respectivement Vc2max, et de réinitialisation de la tension Vc1, respectivement Vc2 soient toutes mises en œuvre pendant que le générateur 102, respectivement 100, délivre une rampe de tension Vc2, respectivement Vc1.

Bien que cela n'ait pas été décrit précédemment en relation avec les figures 1 à 8, les comparateurs COMP1' et COMP2' peuvent présenter chacun un décalage ("offset") entre leurs entrées inverseuse et non inverseuse. Toutefois, de manière usuelle, ce décalage peut être réduit, voire supprimé, lors d'une phase d'étalonnage des comparateurs COMP1' et COMP2'. En outre, bien que ce décalage puisse varier avec la température de l'oscillateur 2, l'influence de la variation de ce décalage avec la température sur la fréquence des signaux fournis par l'oscillateur est négligeable par rapport à celle de la variation du temps de propagation des comparateurs COMP1' et COMP2' avec la température de l'oscillateur. On peut également considérer que ce décalage d'entrée a une influence sur le temps de propagation Tp, et qu'il est donc compensé par la variation de la tension Vref' avec le temps de propagation Tp.

En outre, on a décrit des premiers modes de réalisation et variantes dans lesquels le circuit 200 est configuré pour moduler la tension Vref' sur la base de la valeur maximale Vc1m et de la valeur maximale Vc2m et des deuxièmes modes de réalisation et variantes dans lesquels le circuit 200 est configuré pour moduler la tension Vref' uniquement sur la base de la valeur maximale Vc1m ou uniquement sur la base de la valeur maximale Vc2m. Ces premiers et deuxièmes modes de réalisation et variantes permettent d'obtenir des signaux périodiques, par exemple les signaux ctrl3 et ctrl1 dont la fréquence varie peu, par exemple de moins de 1 %, sur la plage de températures allant de -40 °C à 130 °C. Toutefois, les premiers modes de réalisation et variantes présentent l'avantage supplémentaire que ces signaux périodiques ont également un rapport cyclique qui varie peu, par exemple de moins de 1 % sur la plage de températures allant de -40 °C à 130 °C, par rapport à celui de ces mêmes signaux périodiques dans les deuxièmes modes de réalisation et variantes. Les premiers modes de réalisation et variantes permettent en outre, par rapport aux deuxièmes modes de réalisation et variantes, de corriger d'éventuels décalages entre la valeur de la capacité C1 et celle de la capacité C2, et/ou entre la valeur du courant Ic1 et celle du courant Ic2, et/ou entre la valeur du temps de propagation du comparateur COMP1' et celle du temps de propagation du comparateur COMP2'.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, la personne du métier est en mesure d'adapter les modes de réalisation et variantes décrits :
au cas où les rampes Vc1 et Vc2 sont décroissantes, et/ou
au cas où un ou plusieurs signaux de commande des interrupteurs entraînent la fermeture de ces interrupteurs respectifs quand ces signaux sont à l'état haut plutôt qu'à l'état bas, et/ou
au cas où la tension Vref' est fournie à l'entrée inverseuse du comparateur COMP1 et/ou du comparateur COMP2.

Plus généralement, la personne du métier est en mesure de prévoir d'autres mises en œuvre des circuits 200, 210, 500, 502, 514, 100, 102, 112 et/ou 518 que celles décrites ci-dessus à titre d'exemple.

Enfin, la mise en oeuvre pratique des modes de réalisation et variantes décrits est à la portée de la personne du métier à partir des indications fonctionnelles données ci-dessus. En particulier, la personne du métier est en mesure de mettre en œuvre les circuits 200, 210, 500, 502, 514, 100, 102, 112 et/ou 518 à partir des indications fonctionnelles données ci-dessus.

## Revendications

1. Dispositif (2) comprenant :
un premier générateur (100) de premières rampes de tension (Vc1) et un deuxième générateur (102) de deuxièmes rampes de tension (Vc2) ;
un premier circuit (COMP' ; COMP1', COMP2') configuré pour comparer chaque première rampe (Vc1) avec une tension de consigne (Vref'), pour comparer chaque deuxième rampe (Vc2) avec la tension de consigne (Vref'), pour fournir un premier signal binaire (out1) représentatif de la comparaison de chaque première rampe (Vc1) avec la tension de consigne (Vref'), et pour fournir un deuxième signal binaire (out2) représentatif de la comparaison de chaque deuxième rampe (Vc2) avec la tension de consigne ;
un deuxième circuit (210) configuré, sur la base des premier (out1) et deuxième (out2) signaux, pour :
arrêter une première rampe (Vc1) des premières rampes de tension (Vc1) et démarrer une deuxième rampe (Vc2) des deuxièmes rampes de tension (Vc2) quand ladite première rampe (Vc1) atteint la tension de consigne (Vref'), et
arrêter une deuxième rampe (Vc2) des deuxièmes rampes de tension (Vc2) et démarrer une première rampe (Vc1) des premières rampes de tension (Vc1) quand ladite deuxième rampe (Vc2) atteint la tension de consigne (Vref') ; et
**caractérisé en ce que** le dispositif (2) comprend en outre: un troisième circuit (200, 200-1) configuré:
i) pour
moduler la tension de consigne (Vref') à partir d'une valeur maximale (Vc1max) d'au moins une dernière première rampe (Vc1) comparée à la tension de consigne (Vref'), pour générer un troisième signal (Δ) représentatif d'un écart entre une tension de référence (Vref) et la valeur maximale (Vc1max) d'au moins la dernière première rampe (Vc1), et pour fournir la tension de consigne (Vref') égale à la tension de référence (Vref) moins ledit écart, ou
ii) pour moduler la tension de consigne (Vref') à partir d'une valeur maximale (Vc1max) d'au moins une dernière première rampe (Vc1) comparée à la tension de consigne (Vref') et à partir d'une valeur maximale (Vc2max) d'au moins une dernière deuxième rampe (Vc2) comparée à la tension de consigne (Vref'), pour générer un troisième signal (Δ) représentatif alternativement d'un premier écart entre une tension de référence (Vref) et la valeur maximale (Vc1max) d'au moins la dernière première rampe (Vc1) et d'un deuxième écart entre la tension de référence (Vref) et la valeur maximale d'au moins la dernière deuxième rampe (Vc2), et pour fournir la tension de consigne (Vref') alternativement égale à la tension de référence (Vref) moins le premier écart et à la tension de référence (Vref) moins le deuxième écart,
dans lequel le troisième circuit (200, 200-1) comprend une première source de courant (520) et une résistance (R') connectées en série entre un noeud (106) d'application d'une tension d'alimentation (Vdd) et un noeud (108) d'application d'un potentiel de référence (GND), et un transistor (522) connecté en parallèle de la résistance (R'), une borne de commande du transistor (522) étant configurée pour recevoir le troisième signal (Δ) pour moduler la tension de consigne (Vref').

2. Dispositif selon la revendication 1, dans lequel le deuxième circuit (210) est en outre configuré pour réinitialiser le premier générateur (100) entre chaque deux premières rampes (Vc1) successives, et pour réinitialiser le deuxième générateur (102) entre chaque deux deuxièmes rampes (Vc2) successives.

3. Dispositif selon la revendication 1 ou 2, dans lequel :
le premier générateur (100) comprend une première capacité (C1), un premier interrupteur (SW1) et une deuxième source de courant (104) connectés en série entre le noeud (106) d'application de la tension d'alimentation (Vdd) et le noeud (108) d'application du potentiel de référence (GND), et un deuxième interrupteur (SW2) connecté en parallèle de la première capacité (C1) ; et
le deuxième générateur (102) comprend une deuxième capacité (C2), un troisième interrupteur (SW3) et une troisième source de courant (110) connectés en série entre le noeud (106) d'application de la tension d'alimentation (Vdd) et le noeud (108) d'application du potentiel de référence (GND), et un quatrième interrupteur (SW4) connecté en parallèle de la deuxième capacité (C2),
le deuxième circuit (210) étant configuré sur la base des premier (out1) et deuxième (out2) signaux, pour :
fermer le premier interrupteur (SW1) et ouvrir le troisième interrupteur (SW3) quand une deuxième rampe (Vc2) atteint la tension de consigne (Vref') ; et
fermer le troisième interrupteur (SW3) et ouvrir le premier interrupteur (SW1) quand une première rampe (Vc1) atteint la tension de consigne (Vref').

4. Dispositif selon les revendications 2 et 3, dans lequel le premier générateur (100) est réinitialisé en fermant le deuxième interrupteur (SW2), le deuxième générateur (102) étant réinitialisé en fermant le quatrième interrupteur (SW4), le deuxième circuit (210) étant configuré pour commander les deuxième (SW2) et quatrième (SW4) interrupteurs sur la base des premier (out1) et deuxième (out2) signaux.

5. Dispositif selon la revendication 4, dans lequel le troisième signal (Δ) est représentatif de l'écart entre la tension de référence (Vref) et la valeur maximale (Vc1max) d'au moins ladite dernière première rampe (Vc1), et dans lequel le troisième circuit (200, 200-1) comprend un quatrième circuit (500) configuré pour mettre à jour puis mémoriser une première tension (Vc1-sig) représentative de la valeur maximale (Vc1max) de chaque première rampe (Vc1), entre la fin de chaque première rampe (Vc1) et une réinitialisation suivante du premier générateur (100), le deuxième circuit (210) étant configuré pour commander la mémorisation puis la mise à jour sur la base des premier (out1) et deuxième (out2) signaux.

6. Dispositif selon la revendication 5, dans lequel :
le quatrième circuit (500) comprend une association en série d'une capacité (C1') et d'un interrupteur (SW5), ladite association étant connectée en parallèle de la première capacité (C1) et la première tension (Vc1-sig) étant disponible aux bornes de ladite capacité (C1') ;
la première tension (Vc1-sig) est mise à jour en fermant ledit interrupteur (SW5) et est mémorisée en ouvrant ledit interrupteur (SW5) ; et
le deuxième circuit (210) est configuré pour commander l'interrupteur (SW5) du quatrième circuit (500) sur la base des premier (out1) et deuxième (out2) signaux.

7. Dispositif selon la revendication 5 ou 6, dans lequel le troisième circuit (200, 200-1) comprend un amplificateur d'erreur (512) ayant une première entrée configurée pour recevoir un signal (Vrefsample) représentatif de la tension de référence (Vref), une deuxième entrée configurée pour recevoir la première tension (Vc1-sig), et une borne de sortie configurée pour fournir le troisième signal (Δ).

8. Dispositif selon la revendication 4, dans lequel :
le troisième signal (Δ) est représentatif alternativement du premier écart et du deuxième écart ;
le troisième circuit (200, 200-1) comprend un quatrième circuit (500) configuré pour mettre à jour et mémoriser une première tension (Vc1-sig) représentative de la valeur maximale (Vc1max) de chaque première rampe (Vc1), entre la fin de chaque première rampe (Vc1) et une réinitialisation suivante du premier générateur (100) ;
le troisième circuit (200, 200-1) comprend un cinquième circuit (502) configuré pour mettre à jour et mémoriser une deuxième tension (Vc2-sig) représentative de la valeur maximale de chaque deuxième rampe (Vc2), entre la fin de chaque deuxième rampe (Vc2) et une réinitialisation suivante du deuxième générateur (102) ; et
le deuxième circuit (210) est configuré pour commander les mémorisations et les mises à jour sur la base des premier (out1) et deuxième (out2) signaux.

9. Dispositif selon la revendication 8, dans lequel :
le quatrième circuit (500) comprend une première association en série d'une capacité (C1') et d'un interrupteur (SW5), ladite première association étant connectée en parallèle de la première capacité (C1), la première tension (Vc1-sig) étant disponible aux bornes de la capacité (C1') du quatrième circuit (500), la première tension (Vc1max) étant mise à jour en fermant ledit interrupteur (SW5) et mémorisée en ouvrant ledit interrupteur (SW5) ;
le cinquième circuit (502) comprend une deuxième association en série d'une capacité (C2') et d'un interrupteur (SW6), ladite deuxième association étant connectée en parallèle de la deuxième capacité (C2), la deuxième tension (Vc2-sig) étant disponible aux bornes de la capacité (C2') du cinquième circuit (502), la deuxième tension (Vc2-sig) étant mise à jour en fermant ledit interrupteur (SW6) et mémorisée en ouvrant ledit interrupteur (SW6) ; et
le deuxième circuit (210) est configuré pour commander les interrupteurs (SW5, SW6) des quatrième et cinquième circuits (500, 502) sur la base des premier (out1) et deuxième (out2) signaux.

10. Dispositif selon la revendication 8 ou 9, dans lequel le troisième circuit (200) comprend :
un premier commutateur (504) ayant une borne d'entrée (506) configurée pour recevoir la première tension (Vc1-max), une autre borne d'entrée (508) configurée pour recevoir la deuxième tension (Vc2-sig) ; et
un amplificateur d'erreur (512) ayant une première entrée configurée pour recevoir un signal (Vrefsample) représentatif de la tension de référence (Vref), une deuxième entrée reliée à une borne de sortie (510) du premier commutateur (504) et une borne de sortie configurée pour fournir le troisième signal (Δ), le premier commutateur (504) étant commandé par le deuxième circuit (210) sur la base des premier (out1) et deuxième (out2) signaux.

11. Dispositif selon la revendication 7 ou 10, dans lequel le troisième circuit (200, 200-1) comprend un circuit (514) de mémorisation de la tension de référence (Vref) comprenant :
une capacité (C3) et un premier interrupteur (SW7) reliant un noeud de fourniture de la tension de référence (Vref) à une borne de ladite capacité (C3), l'autre borne de ladite capacité étant reliée au noeud (108) d'application du potentiel de référence (GND) ;
une autre capacité (C3') et un deuxième interrupteur (SW8) reliant un noeud de connexion entre ladite capacité (C3) et ledit premier interrupteur (SW7) à une borne de ladite autre capacité (C3'), une autre borne de ladite autre capacité (C3') étant reliée au noeud (108) d'application du potentiel de référence (GND) et étant configurée pour fournir ledit signal (Vrefsample) représentatif de la tension de référence (Vref) ; et
le deuxième circuit (210) est configuré pour commander les premier et deuxième interrupteurs (SW7, SW8) du circuit de mémorisation (514) sur la base des premier (out1) et deuxième (out2) signaux.

12. Dispositif selon la revendication 11 prise dans sa dépendance à la revendication 10, dans lequel ladite autre borne de ladite autre capacité (C3') est reliée à la première entrée de l'amplificateur d'erreur (512) par un deuxième commutateur (516), le deuxième circuit (210) étant configuré pour commander le deuxième commutateur (516) de manière identique au premier commutateur (504).

## Patentansprüche

1. Einrichtung (2), die Folgendes aufweist:
einen ersten Generator (100) erster Spannungsrampen (Vc1) und einen zweiten Generator (102) zweiter Spannungsrampen (Vc2);
eine erste Schaltung (COMP'; COMP1', COMP2'), die eingerichtet ist zum Vergleichen jeder ersten Rampe (Vc1) mit einer Sollspannung (Vref'), zum Vergleichen jeder zweiten Rampe (Vc2) mit der Sollspannung (Vref'), zum Bereitstellen eines ersten Binärsignals (out1), das repräsentativ für den Vergleich jeder ersten Rampe (Vc1) mit der Sollspannung (Vref') ist, und zum Bereitstellen eines zweiten Binärsignals (out2), das repräsentativ für den Vergleich jeder zweiten Rampe (Vc2) mit der Sollspannung ist;
eine zweite Schaltung (210), die eingerichtet ist, basierend auf dem ersten (out1) und zweiten (out2) Signal, zum:
Stoppen einer ersten Rampe (Vc1) der ersten Spannungsrampen (Vc1) und zum Starten einer zweiten Rampe (Vc2) der zweiten Spannungsrampen (Vc2), wenn die besagte erste Rampe (Vc1) die Sollspannung (Vref') erreicht, und
Stoppen einer zweiten Rampe (Vc2) der zweiten Spannungsrampen (Vc2) und zum Starten einer ersten Rampe (Vc1) der ersten Spannungsrampen (Vc1), wenn die besagte zweite Rampe (Vc2) die Sollspannung (Vref') erreicht; und
**dadurch gekennzeichnet, dass** die Einrichtung (2) ferner aufweist:
eine dritte Schaltung (200, 200-1), die eingerichtet ist:
i) zum Modulieren der Sollspannung (Vref') ausgehend von einem Maximalwert (Vc1max) wenigstens einer letzten ersten Rampe (Vc1), die mit der Sollspannung (Vref') verglichen wurde, zum Erzeugen eines dritten Signals (Δ), das repräsentativ für eine Differenz zwischen einer Referenzspannung (Vref) und dem Maximalwert (Vc1max) wenigstens der letzten ersten Rampe (Vc1) ist, und zum Bereitstellen der Sollspannung (Vref') gleich der Referenzspannung (Vref) minus der besagten Differenz, oder
ii) zum Modulieren der Sollspannung (Vref') ausgehend von einem Maximalwert (Vc1max) wenigstens einer letzten ersten Rampe (Vc1), die mit der Sollspannung (Vref') verglichen wurde, und von einem Maximalwert (Vc2max) wenigstens einer letzten zweiten Rampe (Vc2), die mit der Sollspannung (Vref') verglichen wurde, zum Erzeugen eines dritten Signals (Δ), das alternierend repräsentativ für eine erste Differenz zwischen einer Referenzspannung (Vref) und dem Maximalwert (Vc1max) wenigstens der letzten ersten Rampe (Vc1) und für eine zweite Differenz zwischen der Referenzspannung (Vref) und dem Maximalwert wenigstens der letzten zweiten Rampe (Vc2) ist, und zum Bereitstellen der Sollspannung (Vref') alternierend gleich der Referenzspannung (Vref) minus der ersten Differenz und der Referenzspannung (Vref) minus der zweiten Differenz, wobei die dritte Schaltung (200, 200-1) eine erste Stromquelle (520) und einen Widerstand (R') aufweist, die in Reihe zwischen einem Knoten (106) zum Anlegen einer Versorgungsspannung (Vdd) und einem Knoten (108) zum Anlegen eines Referenzpotenzials (GND) geschaltet sind, sowie einen Transistor (522), der parallel zum Widerstand (R') geschaltet ist, wobei ein Steueranschluss des Transistors (522) eingerichtet ist zum Empfangen des dritten Signals (Δ), um die Sollspannung (Vref') zu modulieren.

2. Einrichtung nach Anspruch 1, wobei die zweite Schaltung (210) ferner eingerichtet ist zum Zurücksetzen des ersten Generators (100) zwischen je zwei aufeinanderfolgenden ersten Rampen (Vc1) und zum Zurücksetzen des zweiten Generators (102) zwischen je zwei aufeinanderfolgenden zweiten Rampen (Vc2).

3. Einrichtung nach Anspruch 1 oder 2, wobei:
der erste Generator (100) einen ersten Kondensator (C1), einen ersten Schalter (SW1) und eine zweite Stromquelle (104) aufweist, die in Reihe zwischen dem Knoten (106) zum Anlegen der Versorgungsspannung (Vdd) und dem Knoten (108) zum Anlegen des Referenzpotenzials (GND) geschaltet sind, sowie einen zweiten Schalter (SW2), der parallel zum ersten Kondensator (C1) geschaltet ist; und
der zweite Generator (102) einen zweiten Kondensator (C2), einen dritten Schalter (SW3) und eine dritte Stromquelle (110) aufweist, die in Reihe zwischen dem Knoten (106) zum Anlegen der Versorgungsspannung (Vdd) und dem Knoten (108) zum Anlegen des Referenzpotenzials (GND) geschaltet sind, sowie einen vierten Schalter (SW4), der parallel zum zweiten Kondensator (C2) geschaltet ist,
wobei die zweite Schaltung (210) eingerichtet ist, basierend auf dem ersten (out1) und zweiten (out2) Signal, zum:
Einschalten des ersten Schalters (SW1) und zum Ausschalten des dritten Schalters (SW3), wenn eine zweite Rampe (Vc2) die Sollspannung (Vref') erreicht; und
Einschalten des dritten Schalters (SW3) und zum Ausschalten des ersten Schalters (SW1), wenn eine erste Rampe (Vc1) die Sollspannung (Vref') erreicht.

4. Einrichtung nach den Ansprüchen 2 und 3, wobei der erste Generator (100) durch das Einschalten des zweiten Schalters (SW2) zurückgesetzt wird, der zweite Generator (102) durch das Einschalten des vierten Schalters (SW4) zurückgesetzt wird, wobei die zweite Schaltung eingerichtet ist zum Steuern des zweiten (SW2) und vierten (SW4) Schalters basierend auf dem ersten (out1) und zweiten (out2) Signal.

5. Einrichtung nach Anspruch 4, wobei das dritte Signal (Δ) repräsentativ für die Differenz zwischen der Referenzspannung (Vref) und dem Maximalwert (Vc1max) wenigstens der besagten letzten ersten Rampe (Vc1) ist, und wobei die dritte Schaltung (200, 200-1) eine vierte Schaltung (500) aufweist, die eingerichtet ist zum Aktualisieren und anschließenden Speichern einer ersten Spannung (Vc1-sig), die repräsentativ für den Maximalwert (Vc1max) jeder ersten Rampe (Vc1) ist, zwischen dem Ende jeder ersten Rampe (Vc1) und einem nächsten Zurücksetzen des ersten Generators (100), wobei die zweite Schaltung (210) eingerichtet ist zum Steuern der Speicherung und anschließenden Aktualisierung basierend auf dem ersten (out1) und zweiten (out2) Signal.

6. Einrichtung nach Anspruch 5, wobei:
die vierte Schaltung (500) eine Reihenschaltung eines Kondensators (C1') und eines Schalters (SW5) aufweist, wobei die besagte Reihenschaltung parallel zum ersten Kondensator (C1) geschaltet ist, und die erste Spannung (Vc1-sig) an dem besagten Kondensator (C1') abgreifbar ist;
die erste Spannung (Vc1-sig) durch das Einschalten des besagten Schalters (SW5) aktualisiert und durch das Ausschalten des besagten Schalters (SW5) gespeichert wird; und
die zweite Schaltung (210) eingerichtet ist zum Steuern des Schalters (SW5) der vierten Schaltung (500) basierend auf dem ersten (out1) und zweiten (out2) Signal.

7. Einrichtung nach Anspruch 5 oder 6, wobei die dritte Schaltung (200, 200-1) einen Fehler-Verstärker (512) aufweist, der einen ersten Eingang, der eingerichtet ist zum Empfangen eines Signals (Vrefsample), das repräsentativ für die Referenzspannung (Vref) ist, einen zweiten Eingang, der eingerichtet ist zum Empfangen der ersten Spannung (Vc1-sig), und einen Ausgangsanschluss aufweist, der eingerichtet ist zum Bereitstellen des dritten Signals (Δ).

8. Einrichtung nach Anspruch 4, wobei:
das dritte Signal (Δ) repräsentativ für die erste Differenz und die zweite Differenz ist;
die dritte Schaltung (200, 200-1) eine vierte Schaltung (500) aufweist, die eingerichtet ist zum Aktualisieren und anschließenden Speichern einer ersten Spannung (Vc1-sig), die repräsentativ für den Maximalwert (Vc1max) jeder ersten Rampe (Vc1) ist, zwischen dem Ende jeder ersten Rampe (Vc1) und einem nächsten Zurücksetzen des ersten Generators (100);
die dritte Schaltung (200, 200-1) eine fünfte Schaltung (502) aufweist, die eingerichtet ist zum Aktualisieren und Speichern einer zweiten Spannung (Vc2-sig), die repräsentativ für den Maximalwert jeder zweiten Rampe (Vc2) ist, zwischen dem Ende jeder zweiten Rampe (Vc2) und einem nächsten Zurücksetzen des zweiten Generators (102); und
die zweite Schaltung (210) eingerichtet ist zum Steuern der Speicherungen und der Aktualisierungen basierend auf dem ersten (out1) und zweiten (out2) Signal.

9. Einrichtung nach Anspruch 8, wobei:
die vierte Schaltung (500) eine erste Reihenschaltung eines Kondensators (C1') und eines Schalters (SW5) aufweist, wobei die besagte erste Reihenschaltung parallel zum ersten Kondensator (C1) geschaltet ist, wobei die erste Spannung (Vc1-sig) an dem Kondensator (C1') der vierten Schaltung (500) abgreifbar ist, wobei der erste Maximalwert (Vc1max) durch das Einschalten des besagten Schalters (SW5) aktualisiert und durch das Ausschalten des besagten Schalters (SW5) gespeichert wird;
die fünfte Schaltung (502) eine zweite Reihenschaltung eines Kondensators (C2') und eines Schalters (SW6) aufweist, wobei die besagte zweite Reihenschaltung parallel zum zweiten Kondensator (C2) geschaltet ist, wobei die zweite Spannung (Vc2-sig) an dem Kondensator (C2') der fünften Schaltung (502) abgreifbar ist, wobei die zweite Spannung (Vc2-sig) durch das Einschalten des besagten Schalters (SW6) aktualisiert und durch das Ausschalten des besagten Schalters (SW6) gespeichert wird; und
die zweite Schaltung (210) eingerichtet ist zum Steuern der Schalter (SW5, SW6) der vierten und fünften Schaltung (500, 502) basierend auf dem ersten (out1) und zweiten (out2) Signal.

10. Einrichtung nach Anspruch 8 oder 9, wobei die dritte Schaltung (200) aufweist:
einen ersten Kommutator (504), der einen Eingangsanschluss (506), der eingerichtet ist zum Empfangen der ersten Spannung (Vc1-max), und einen weiteren Eingangsanschluss (508) aufweist, der eingerichtet ist zum Empfangen der zweiten Spannung (Vc2-sig); und
einen Fehler-Verstärker (512), der einen ersten Eingang, der eingerichtet ist zum Empfangen eines Signals (Vrefsample), das repräsentativ für die Referenzspannung (Vref) ist, einen zweiten Eingang, der mit einem Ausgangsanschluss (510) des ersten Kommutators (504) gekoppelt ist, und einen Ausgangsanschluss aufweist, der eingerichtet ist zum Bereitstellen des dritten Signals (Δ), wobei der erste Kommutator (504) durch die zweite Schaltung (210) basierend auf dem ersten (out1) und zweiten (out2) Signal gesteuert wird.

11. Einrichtung nach Anspruch 7 oder 10, wobei die dritte Schaltung (200, 200-1) eine Schaltung (514) zum Speichern der Referenzspannung (Vref) aufweist, die Folgendes aufweist:
einen Kondensator (C3) und einen ersten Schalter (SW7), der einen Knoten zur Zuführung der Referenzspannung (Vref) mit einem Anschluss des besagten Kondensators (C3) koppelt, wobei der andere Anschluss des besagten Kondensators mit dem Knoten (108) zum Anlegen des Referenzpotenzials (GND) gekoppelt ist;
einen weiteren Kondensator (C3') und einen zweiten Schalter (SW8), der einen Verbindungsknoten zwischen dem besagten Kondensator (C3) und dem besagten ersten Schalter (SW7) mit einem Anschluss des besagten weiteren Kondensators (C3') koppelt, wobei ein anderer Anschluss des besagten weiteren Kondensators (C3') mit dem Knoten (108) zum Anlegen des Referenzpotenzials (GND) gekoppelt ist und eingerichtet ist zum Bereitstellen des besagten Signals (Vrefsample), das repräsentativ für die Referenzspannung (Vref) ist; und
die zweite Schaltung (210) eingerichtet ist zum Steuern des ersten und zweiten Schalters (SW7, SW8) der Speicher-Schaltung (514) basierend auf dem ersten (out1) und zweiten (out2) Signal.

12. Einrichtung nach Anspruch 11 in Abhängigkeit von Anspruch 10, wobei der besagte andere Anschluss des besagten weiteren Kondensators (C3') mit dem ersten Eingang des Fehler-Verstärkers (512) durch einen zweiten Kommutator (516) gekoppelt ist, wobei die zweite Schaltung (210) eingerichtet ist zum Steuern des zweiten Kommutators (516) in gleicher Weise wie den ersten Kommutator (504).

## Claims

1. Device (2) comprising:
a first generator (100) of first voltage ramps (Vc1), and a second generator (102) of second voltage ramps (Vc2);
a first circuit (COMP'; COMP1', COMP2') configured to compare each first ramp (Vc1) with a setpoint voltage (Vref'), to compare each second ramp (Vc2) with the setpoint voltage (Vref'), to provide a first binary signal (out1) representative of the comparison of each first ramp (Vc1) with the setpoint voltage (Vref'), and to provide a second binary signal (out2) representative of the comparison of each second ramp (Vc2) with the setpoint voltage;
a second circuit (210) configured, based on the first (out1) and second (out2) signals, to:
stop a first ramp (Vc1) of the first voltage ramps (Vc1), and start a second ramp (Vc2) of the second voltage ramps (Vc2) when said first ramp (Vc1) reaches the setpoint voltage (Vref'), and
stop a second ramp (Vc2) of the second voltage ramps (Vc2), and start a first ramp (Vc1) of the first voltage ramps (Vc1) when said second ramp (Vc2) reaches the setpoint voltage (Vref'); and
**characterized in that** the device (2) further comprises:
a third circuit (200, 200-1) configured:
i) to modulate the setpoint voltage (Vref') from a maximum value (Vc1max) of at least a last first ramp (Vc1) compared to the setpoint voltage (Vref'), to generate a third signal (Δ) representative of a difference between a reference voltage (Vref) and the maximum value (Vc1max) of at least the last first ramp (Vc1), and to provide the setpoint voltage (Vref') equal to the reference voltage (Vref) minus said difference, or
ii) to modulate the setpoint voltage (Vref') from a maximum value (Vc1max) of at least one last first ramp (Vc1) compared with the setpoint voltage (Vref') and from a maximum value (Vc2max) of at least one last second ramp (Vc2) compared with the setpoint voltage (Vref'), to generate a third signal (Δ) alternately representative of a first difference between a reference voltage (Vref) and the maximum value (Vc1max) of at least the last first ramp (Vc1) and of a second difference between the reference voltage (Vref) and the maximum value of at least the last second ramp (Vc2), and to provide the setpoint voltage (Vref') alternately equal to the reference voltage (Vref) minus the first difference and to the reference voltage (Vref) minus the second difference,
wherein the third circuit (200, 200-1) comprises a first current source (520) and a resistor (R') series-connected between a node (106) for applying a power supply voltage (Vdd) and a node (108) for applying a reference potential (GND), and a transistor (522) parallel-connected with the resistor (R'), a control terminal of the transistor (522) being configured to receive the third signal (Δ) to modulate the setpoint voltage (Vref').

2. Device according to claim 1, wherein the second circuit (210) is further configured to reset the first generator (100) between every two consecutive first ramps (Vc1), and to reset the second generator (102) between every two consecutive second ramps (Vc2).

3. Device according to claim 1 or 2, wherein:
the first generator (100) comprises a first capacitor (C1), a first switch (SW1), and a second current source (104) series-connected between the node (106) for applying the power supply voltage (Vdd) and the node (108) for applying the reference potential (GND), and a second switch (SW2) parallel-connected with the first capacitor (C1); and
the second generator (102) comprises a second capacitor (C2), a third switch (SW3), and a third current source (110) series-connected between the node (106) for applying the power supply voltage (Vdd) and the node (108) for applying the reference potential (GND), and a fourth switch (SW4) parallel-connected with the second capacitor (C2),
the second circuit (210) being configured, based on the first (out1) and second (out2) signals, to:
turn on the first switch (SW1) and turn off the third switch (SW3) when a second ramp (Vc2) reaches the setpoint voltage (Vref'); and
turn on the third switch (SW3) and turn off the first switch (SW1) when a first ramp (Vc1) reaches the setpoint voltage (Vref').

4. Device according to claims 2 and 3, wherein the first generator (100) is reset by the turning-on of the second switch (SW2), the second generator (102) being reset by the turning-on of the fourth switch (SW4), the second circuit being configured to control the second (SW2) and fourth (SW4) switches based on the first (out1) and second (out2) signals.

5. Device according to claim 4, wherein the third signal (Δ) is representative of the difference between the reference voltage (Vref) and the maximum value (Vc1max) of at least said last first ramp (Vc1), and wherein the third circuit (200, 200-1) comprises a fourth circuit (500) configured to update and then store a first voltage (Vc1-sig) representative of the maximum value (Vc1max) of each first ramp (Vc1), between the end of each first ramp (Vc1) and a next resetting of the first generator (100), the second circuit (210) being configured to control the storage and then the update based on the first (out1) and second (out2) signals.

6. Device according to claim 5, wherein:
the fourth circuit (500) comprises a series association of a capacitor (C1') and of a switch (SW5), said association being parallel-connected with the first capacitor (C1), and the first voltage (Vc1-sig) being available across said capacitor (C1');
the first voltage (Vc1-sig) is updated by the turning-on of said switch (SW5) and stored by the turning-off of said switch (SW5); and
the second circuit (210) is configured to control the switch (SW5) of the fourth circuit (500) based on the first (out1) and second (out2) signals.

7. Device according to claim 5 or 6, wherein the third circuit (200, 200-1) comprises an error amplifier (512) having a first input configured to receive a signal (Vrefsample) representative of the reference voltage (Vref), a second input configured to receive the first voltage (Vc1-sig), and an output terminal configured to provide the third signal (Δ).

8. Device according to claim 4, wherein:
the third signal (Δ) is representative of the first difference and the second difference;
the third circuit (200, 200-1) comprises a fourth circuit (500) configured to update and then store a first voltage (Vc1-sig) representative of the maximum value (Vc1max) of each first ramp (Vc1), between the end of each first ramp (Vc1) and a next resetting of the first generator (100);
the third circuit (200, 200-1) comprises a fifth circuit (502) configured to update and store a second voltage (Vc2-sig) representative of the maximum value of each second ramp (Vc2), between the end of each second ramp (Vc2) and a next resetting of the second generator (102); and
the second circuit (210) is configured to control the storages and the updates based on the first (out1) and second (out2) signals.

9. Device according to claim 8, wherein:
the fourth circuit (500) comprises a first series association of a capacitor (C1') and of a switch (SW5), said first association being parallel-connected with the first capacitor (C1), the first voltage (Vc1-sig) being available across the capacitor (C1') of the fourth circuit (500), the first voltage (Vc1max) being updated by the turning-on of said switch (SW5) and stored by the turning-off of said switch (SW5);
the fifth circuit (502) comprises a second series association of a capacitor (C2') and of a switch (SW6), said second series association being parallel-connected with the second capacitor (C2), the second voltage (Vc2-sig) being available across the capacitor (C2') of the fifth circuit (502), the second voltage (Vc2-sig) being updated by the turning-on of said switch (SW6) and stored by the turning-off of said switch (SW6); and
the second circuit (210) is configured to control the switches (SW5, SW6) of the fourth and fifth circuits (500, 502) based on the first (out1) and second (out2) signals.

10. Device according to claim 8 or 9, wherein the third circuit (200) comprises:
a first commutator (504) having an input terminal (506) configured to receive the first voltage (Vc1-max), another input terminal (508) configured to receive the second voltage (Vc2-sig); and
an error amplifier (512) having a first input configured to receive a signal (Vrefsample) representative of the reference voltage (Vref), a second input coupled to an output terminal (510) of the first commutator (504) and an output terminal configured to provide the third signal (Δ), the first commutator (504) being controlled by the second circuit (210) based on the first (out1) and second (out2) signals.

11. Device according to claim 7 or 10, wherein the third circuit (200, 200-1) comprises a circuit (514) for storing the reference voltage (Vref) comprising:
a capacitor (C3) and a first switch (SW7) coupling a node for supplying the reference voltage (Vref) to a terminal of said capacitor (C3), the other terminal of said capacitor being coupled to the node (108) for applying the reference potential (GND);
another capacitor (C3') and a second switch (SW8) coupling a node of connection between said capacitor (C3) and said first switch (SW7) to a terminal of said other capacitor (C3'), another terminal of said other capacitor (C3') being coupled to the node (108) for applying the reference potential (GND) and being configured to provide said signal (Vrefsample) representative of the reference voltage (Vref); and
the second circuit (210) is configured to control the first and second switches (SW7, SW8) of the storage circuit (514) based on the first (out1) and second (out2) signals.

12. Device according to claim 11 as dependent on claim 10, wherein said other terminal of said other capacitive element (C3') is coupled to the first input of the error amplifier (512) by a second commutator (516), the second circuit (210) being configured to control the second commutator (516) similarly to the first commutator (504).
